# EUROPEAN PATENT SPECIFICATION

(11) **EP 0 476 589 B1**
(45) Date of publication and mention of the grant of the patent: **12.06.1996**
(21) Application number: 91115755.0
(22) Date of filing: 17.09.1991
(51) Int. Cl.: H05K 3/46, H01L 23/538

(54) **Multi-layer wiring substrate and production thereof**
Mehrschichtiges, Leiter enthaltendes Substrat und Herstellungsverfahren dafür
Substrat à circuits électriques multicouches et méthode de sa fabrication

(30) Priority: 21.09.1990 JP 252311/90
(43) Date of publication of application: 25.03.1992
(73) Proprietor: HITACHI, LTD., Chiyoda-ku, Tokyo 101 (JP)
(72) Inventor: Suzuki, Masahiro, Iwaki-shi (JP); Nagai, Akira, Mizukicho-2-chome, Hitachi-shi (JP); Katagiri, Junichi, Naka-gun, Ibaraki-ken (JP); Takahashi, Akio, Hitachiota-shi (JP); Mukoh, Akio, Mito-shi (JP); Miura, Osamu, Hitachi-shi (JP); Nishikawa, Akio, Hitachi-shi (JP)
(74) Representative: Patentanwälte Beetz - Timpe - Siegfried Schmitt-Fumian - Mayr

(56) References cited:
- EP-A- 0 032 745
- EP-A- 0 059 434
- EP-A- 0 202 498
- DE-A- 2 204 957

## Description

### BACKGROUND OF THE INVENTION

This invention relates to a multi-layer wiring substrate for directly mounting chips or chip carriers which is used in various electronic devices, and a process for producing the same.

Multi-layer wiring substrates for directly mounting chips or chip carriers (hereinafter referred to as "module wiring substrate") require heat resistance of higher than 300°C, preferably 320°C or higher, more preferably 350°C or higher, for soldering chips or chip carriers thereon different from ordinary multi-layer printed wiring boards (usually heat resistance of 220°C or higher). As such module wiring substrates, there have been used ceramic wiring substrates and multi-layer wiring substrates obtained by laminating polyimide films or a ceramic wiring substrate by the so-called sequential laminating method.

However, since the ceramic wiring substrates have a molding temperature of as high as 1200°C to 1500°C, it is impossible to use a copper conductor having a melting point lower than such a temperature and having lower electrical resistance. Further, drilling of very fine holes is difficult and misregistration at the time of multi-layer lamination is large due to molding shrinkage of 15 to 20%, resulting in failing to obtain high density mounting. In addition, since the relative dielectric constant is as high as 6 to 9, undesirable influences are made on the signal transfer rate of the module wiring substrates. The multi-layer wiring substrates obtained by laminating several polyimide insulating layers on a ceramic multi-layer substrate by the sequential laminating method (Japanese Patent Unexamined Publication Nos. 62-111456 and 62-111457) have problems in that the relative dielectric constant is high, the production steps are complicated due to the sequential lamination in spite of easiness in obtaining very fine wirings, poor in yield of final products and poor adhesiveness to the conductor layers. Further, these Japanese patent references are quite silent on what kinds of polyimides are used therein.

Japanese Patent Unexamined Publication No. 2-45998 discloses a multi-layer wiring substrate suitable as the module substrate obtained by siamese lamination of a wiring substrate obtained by forming conductors on a dehydration condensation type polyimide film using an organic adhesive including polyimide. The polyimide film is excellent in flexibility but poor in adhesiveness to the copper conductor. Further, when two polyimide films are to be adhered, since adhesive has poor high temperature fluidity, it does not flow into spaces of 20 to 50 µm between patterns, resulting in producing voids between patterns, producing blisters between the layers (films) and making the resulting laminate easily peel. When the polyimide composition disclosed in Japanese Patent Unexamined Publication No. 62-235383 is used as the organic adhesive mentioned above, solder heat resistance of higher than 300°C, more preferably higher than 320°C, which temperature is necessary for directly mounting chips or chip carriers, cannot be obtained.

On the other hand, polyether imides having a heat resistance of, for example, 100° to 300°C are disclosed in U.S. Patent No. 4,460,783. But said U.S. Patent only discloses the use of such polyether imides for forming shaped articles and is quite silent on using such polyether imides for the module wiring substrates requiring special properties different from shaped articles. Further, Japanese Patent Unexamined Publication No. 2-127408 discloses an etherimide composition comprising an ether unsaturated bisimide compound and a fluorine-containing amine derivative, which can be used as a material for forming a laminate, a packaging material of semiconductor devices, etc. But this reference is quite silent on whether such a composition is suitable for forming the module wiring substrates or not, since the solder heat resistance test at 300°C is only disclosed therein.

### SUMMARY OF THE INVENTION

It is the object of the present invention to provide a multi-layer wiring substrate for directly mounting chips or chip carriers excellent in flexibility even in thickness of 30 to 80 µm, having solder heat resistance of higher than 300°C, preferably 320°C or higher, more preferably 350°C or higher, at the time of mounting chips or chip carriers, and excellent high temperature fluidity for filling spaces of 20 to 50 µm between patterns with the resin of an insulating layer, and good adhesiveness to copper conductors. It is another object of the present invention to provide a process for producing such a multi-layer wiring substrate.

The present invention provides a multi-layer wiring substrate for directly mounting chips or chip carriers obtained by laminating a plurality of circuit substrates via adhesive layers, each circuit substrate comprising an insulating layer at least one surface of which has a conductor circuit thereon, and at least one of said insulating layer and said adhesive layer being the cured product of an ether imide compound of the formula: 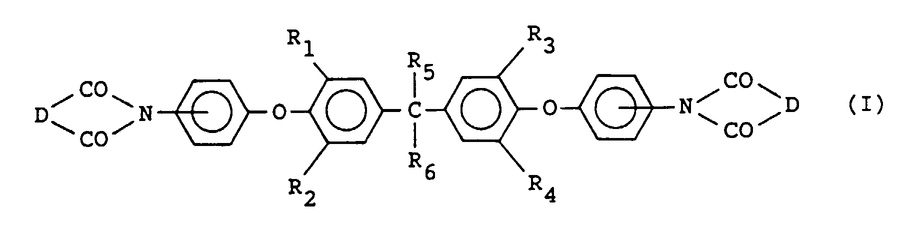 wherein R₁, R₂, R₃ and R₄ are independently a hydrogen atom, an alkyl group having 1 to 6 carbon atoms, an alkoxy group having 1 to 6 carbon atoms, or a halogen atom, R₅ and R₆ are independently a hydrogen atom, a methyl group, an ethyl group, a trifluoromethyl group or a trichloromethyl group, and D is a residue of dicarboxylic acid having one or more ethylenically unsaturated double bonds.

The present invention also provides a process for producing such a multi-layer wiring substrate.

### BRIEF DESCRIPTION OF THE DRAWINGS

Figs. 1A to 1D are cross-sectional views explaining steps for producing one example of the multi-layer wiring substrate of the present invention.

Figs. 2A to 2D are cross-sectional views explaining steps for producing another example of the multi-layer wiring substrate of the present invention.

### DESCRIPTION OF THE PRESENT INVENTION

The multi-layer wiring substrate for directly mounting chips or chip carriers (module wiring substrate) of the present invention obtained by laminating a plurality of circuit substrates via adhesive layers, each circuit substrate comprising an insulating layer at least one surface of which has a conductor circuit thereon, is characterized in that at least one of said insulating layer and said adhesive layer is a cured product of an ether imide compound of the formula: 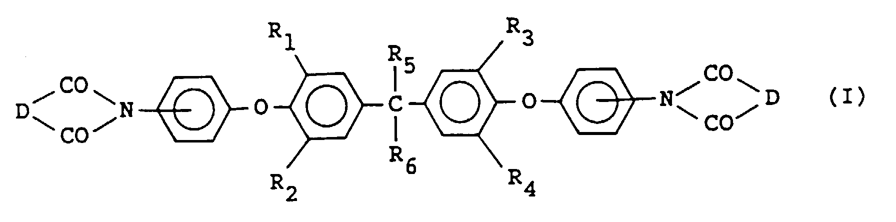 wherein R₁, R₂, R₃ and R₄ are independently a hydrogen atom, an alkyl group having 1 to 6 carbon atoms, an alkoxy group having 1 to 6 carbon atoms, or a halogen atom such as chlorine, bromine, etc., R₅ and R₆ are independently a hydrogen atom, a methyl group, an ethyl group, a trifluoromethyl group or a trichloromethyl group, and D is a residue of dicarboxylic acid having one or more ethylenically unsaturated double bonds.

Concrete examples of the ether imide compound of the formula (I) are as follows:
2,2-bis[4-(4-maleimidophenoxy)phenyl]propane,
2,2-bis[3-methyl-4-(4-maleimidophenoxy)phenyl]propane,
2,2-bis[3-chloro-4-(4-maleimidophenoxy)phenyl]propane,
2,2-bis[3-bromo-4-(4-maleimidophenoxy)phenyl]propane,
2,2-bis[3-ethyl-4-(4-maleimidophenoxy)phenyl]propane,
2,2-bis[3-propyl-4-(4-maleimidophenoxy)phenyl]propane,
2,2-bis[3-isopropyl-4-(4-maleimidophenoxy)phenyl]propane,
2,2-bis[3-butyl-4-(4-maleimidophenoxy)phenyl]propane,
2,2-bis[3-sec-butyl-4-(4-maleimidophenoxy)phenyl]propane,
2,2-bis[3-methoxy-4-(4-maleimidophenoxy)phenyl]propane,
1,1-bis[4-(4-maleimidophenoxy)phenyl]ethane,
1,1-bis[3-methyl-4-(4-maleimidophenoxy)phenyl]ethane,
1,1-bis[3-chloro-4-(4-maleimidophenoxy)phenyl]ethane,
1,1-bis[3-bromo-4-(4-maleimidophenoxy)phenyl]ethane,
bis[4-(4-maleimidophenoxy)phenyl]methane,
bis[3-methyl-4-(4-maleimidophenoxy)phenyl]methane,
bis[3-chloro-4-(4-maleimidophenoxy)phenyl]methane,
bis[3-bromo-4-(4-maleimidophenoxy)phenyl]methane,
1,1,1,3,3,3-hexafluoro-2,2-bis[4-(4-maleimidophenoxy)phenyl]propane,
1,1,1,3,3,3-hexachloro-2,2-bis[4-(4-maleimidophenoxy)phenyl]propane,
3,3-bis[4-(4-maleimido)phenyl]pentane,
1,1-bis[4-(4-maleimidophenoxy)phenyl]propane,
1,1,1,3,3,3-hexafluoro-2,2-bis[3,5-dimethyl-(4-maleimidophenoxy)phenyl]propane,
1,1,1,3,3,3-hexafluoro-2,2-bis[3,5-methyl-(4-maleimidophenoxy)phenyl]propane, etc.

The ether imide compound of the formula (I) can be produced by reacting an ether linkage-containing diamine compound of the formula: 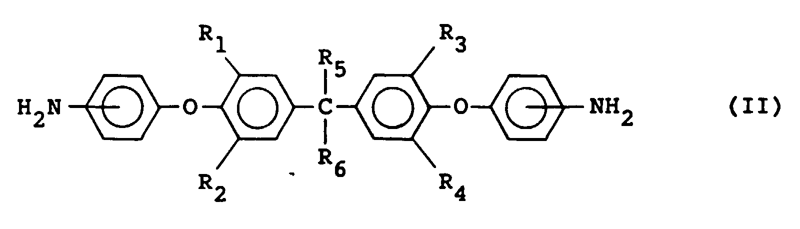 wherein R₁ through R₆ are as defined above, with an acid anhydride of the formula: 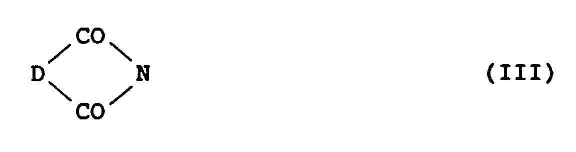 wherein D is as defined above, in an organic solvent preferably at -10° to +40°C for 0.5 to 10 hours to yield an ether maleic amic acid of the formula: 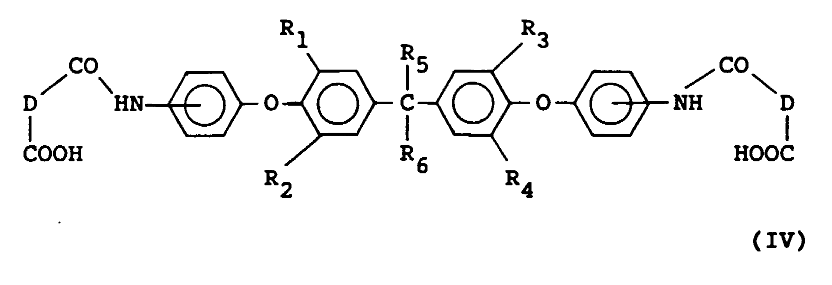 wherein R₁ through R₆ and D are as defined above, followed by dehydration ring closure to form imide rings, preferably at 60° to 120°C for about 0.5 to 3 hours.

Concrete examples of the diamine compound of the formula (II) are as follows:
2,2-bis[4-(4-aminophenoxy)phenyl]propane,
2,2-bis[3-methyl-4-(4-aminophenyl)phenyl]propane,
2,2-bis[3-chloro-4-(4-aminophenoxy)phenyl]propane,
2,2-bis[3-bromo-4-(4-aminophenoxy)phenyl]propane,
2,2-bis[3-ethyl-4-(4-aminophenoxy)phenyl]propane,
2,2-bis[3-propyl-4-(4-aminophenoxy)phenyl]propane,
2,2-bis[3-isopropyl-4-(4-aminophenoxy)phenylpropane,
2,2-bis[3-butyl-4-(4-aminophenoxy)phenyl]propane,
2,2-bis[3-sec-butyl-4-(4-aminophenoxy)phenyl]propane,
2,2-bis[3-methoxy-4-(4-aminophenoxy)phenyl]propane,
1,1-bis[4-(4-aminophenoxy)phenyl]ethane,
1,1-bis[3-methyl-4-(4-aminophenoxy)phenyl]ethane,
1,1-bis[3-chloro-4-(4-aminophenoxy)phenyl]ethane,
1,1-bis[3-bromo-4-(4-aminophenoxy)phenyl]ethane,
bis[4-(4-aminophenoxy)phenyl]methane,
bis[3-methyl-4-(4-aminophenoxy)phenyl]methane,
bis[3-chloro-4-(4-aminophenoxy)phenyl)methane,
bis[3-bromo-4-(4-aminophenoxy)phenyl]methane,
1,1,1,3,3,3-hexafluoro-2,2-bis[4-(4-aminophenoxy)phenyl]propane,
1,1,1,3,3,3-hexachloro-2,2-bis[4-(4-aminophenoxy)phenyl]propane,
3,3-bis[4-(4-aminophenoxy)phenyl]pentane,
1,1-bis[4-(4-aminophenoxy)phenyl]pentane,
1,1,1,3,3,3-hexafluoro-2,2-bis[3,5-dimethyl-(4-aminophenoxy)phenyl]propane,
1,1,1,3,3,3-hexafluoro-2,2-bis[3,5-dibromo-(4-aminophenoxy)phenyl]propane,
1,1,1,3,3,3-hexafluoro-2,2-bis[3,5-methyl-(4-aminophenoxy)phenyl]propane, etc.

Examples of the ethylenically unsaturated dicarboxylic acid anhydride of the formula (III) are maleic anhydride, citraconic anhydride, itaconic anhydride, pyrocinchonic anhydride, dichloromaleic anhydride, etc.

Examples of the organic solvent are dimethylformamide, dimethylacetamide, dimethylsulfoxide, N-methyl-pyrrolidone, N-methyl caprolactam, tetrahydrofuran, dioxane, acetone, diethyl ketone, methyl ethyl ketone, toluene, etc.

The reaction disclosed in U.S. Patent Nos. 3,018,290; 3,018,292 and 3,127,414 can be applied to the reaction mentioned above.

The ether imide compound of the formula (I) can be used together with one or more aromatic cyanamide compounds, cyanurate compounds and cyanate compounds.

Examples of the aromatic cyanamide compound are as follows:
4,4'-dicyanamidodicyclohexylmethane,
1,4-dicyanamidodicyclohexylmethane,
2,6-dicyanamidopyridine,
m-phenylenedicyanamide,
p-phenylenedicyanamide,
4,4'-dicyanamidodiphenylmethane,
2,2'-bis(4-dicyanamidophenyl)propane,
4,4'-dicyanamidophenyl oxide,
4,4'-dicyanamidodiphenylsulfone,
bis(4-bis(4-cyanamidophenyl)phosphine oxide,
bis(4-cyanamidophenyl)phenylphosphine oxide,
bis(4-cyanamidophenyl)methylamine,
1,5-dicyanamidonaphthalene,
m-xylylenedicyanamide,
1,1-bis(p-cyanamidophenyl)furan,
p-xylylenedicyanamide,
hexamethylenedicyanamide,
6,6'-dicyanamido-2,2-dipyridyl,
4,4-dicyanamidobenzophenone,
4,4'-dicyanamidoazobenzene,
bis(4-cyanamidophenyl)phenylmethane,
1,1-bis(4-cyanamidophenyl)cyclohexane,
1,1-bis(4-cyanamido-methylphenyl)-1,3,4-oxadiazole,
4,4'-dicyanamidodiphenyl ether,
4,4-bis(p-cyanamidophenyl)-2,2-dithiazole,
m-bis(4-p-cyanamidophenyl-2-thiazole)benzene,
4,4-dicyanamidobenzanilide,
4,4'-dicyanamidophenyl benzoate,
2,2'-bis[4-(4-cyanamidophenoxy)phenyl]propane,
2,2'-bis[3-methyl-4-(4-cyanamidophenoxy)phenyl]propane,
2,2'-bis[3-ethyl-4-(4-cyanamidophenoxy)phenyl]propane,
2,2'-bis[3-propyl-4-(4-cyanamidophenoxy)phenyl]propane,
2,2'-bis[3-isopropyl-4-(4-cyanamidophenoxy)phenyl]propane,
bis[4-(4-cyanamidophenoxy)phenyl]methane,
1,1,1,3,3,3-hexafluoro-2,2-bis[4-(4-maleimidophenoxy)phenyl]propane,
1,1,1,3,3,3-hexachloro-2,2-bis[4-(4-cyanamidophenoxy)phenyl]propane,
3,3-bis[4-(4-cyanamido)phenyl]pentane,
1,1-bis[4-(4-cyanamidophenoxy)phenyl]propane,
1,1,1,3,3,3-hexafluoro-2,2-bis[3,5-dimethyl-(4-cyanamidophenoxy)phenyl]propane,
1,1,1,3,3,3-hexafluoro-2,2-bis[3,5-dibromo-(4-cyanamidophenoxy)phenyl]propane,
1,1,1,3,3,3-hexafluoro-2,2-bis[3,5-dimethyl-(4-cyanamidophenoxy)phenyl]propane, etc.

The aromatic cyanamide compound can preferably be used in an amount of 30% by weight or less based on the total weight of the aromatic cyanamide compound and the ether imide compound of the formula (I), in order to obtain a cured product satisfying the objects of the present invention such as excellent heat resistance.

Examples of the cyanurate compounds are as follows:
4,4'-cyanurate dicyclohexylmethane,
1,4-cyanurate dicyclohexylmethane,
2,6-cyanurate pyridine,
m-phenylene cyanurate,
p-cyanurate phenylene,
4,4'-cyanurate diphenylmethane,
2,2'-bis(4-cyanurate phenyl)propane,
4,4'-cyanurate phenyl oxide,
4,4'-cyanurate diphenyl sulfone,
bis(4-cyanurate phenyl)phosphine oxide,
bis(4-cyanurate phenyl)phenylphosphine oxide,
bis(4-cyanurate phenyl)methylamine,
1,5-cyanurate naphthalene,
m-xylylene cyanurate,
1,1-bis(p-cyanurate phenyl)furan,
p-xylylene cyanurate,
hexamethylene cyanurate,
6,6'-cyanurate-2,2-dipyridyl,
4,4-cyanurate benzophenone,
4,4'-cyanurate azobenzene,
bis(4-cyanurate phenyl)phenylmethane,
1,1-bis(4-cyanurate phenyl)cyclohexane,
1,1-bis(4-cyanurate-methylphenyl)-1,3,4-oxathiazole,
4,4'-cyanurate diphenyl ether,
4,4-bis(p-cyanurate phenyl)-2,2-dithiazole,
m-bis(4-p-cyanurate phenyl-2-thiazole)benzene,
4,4'-cyanurate benzaniline,
4,4'-cyanurate phenyl benzoate,
2,2'-bis[4-(4-cyanurate phenoxy)phenyl]propane,
2,2'-bis[3-methyl-4-(4-cyanurate phenoxy)-phenyl]propane,
2,2'-bis[3-ethyl-4-(4-cyanurate phenoxy)-phenyl]propane,
2,2'-bis[3-propyl-4-(4-cyanurate phenoxy)-phenyl]propane,
2,2'-bis[3-isopropyl-4-(4-cyanurate phenoxy)-phenyl]propane,
bis[4-(4-cyanurate phenoxy)phenyl]methane-1,1,1,3,3,3-hexafluoropropane,
1,1,1,3,3,3-hexachloro-2,2-bis[4-(4-cyanurate phenoxy)phenyl]propane,
3,3-bis[4-(4-cyanurate)phenyl]pentane,
1,1-bis[4-(4-cyanurate phenoxy)phenyl]propane,
1,1,1,3,3,3-hexafluoro-2,2-bis[3,5-dimethyl-(4-cyanurate phenoxy)phenyl]propane,
1,1,1,3,3,3-hexafluoro-2,2-bis[3,5-dibromo-(4-cyanurate phenoxy)phenyl]propane,
1,1,1,3,3,3-hexafluoro-2,2-bis[3,5-methyl-(4-cyanurate phenoxy)phenyl]propane, etc.

The cyanurate compound can preferably be used in an amount of 40% by weight or less based on the total weight of the cyanurate compound and the ether imide compound of the formula (I) in order to obtain a cured product satisfying the objects of the present invention such as excellent heat resistance.

Examples of the isocyanate compounds are as follows:
4,4'-cyanate dicyclohexylmethane,
1,4-cyanate dicyclohexylmethane,
2,6-cyanate dicyclohexylmethane,
2,6-cyanate pyridine,
m-phenylene cyanate,
p-cyanate phenylene,
4,4'-cyanate diphenylmethane,
2,2'-bis(4-cyanate phenyl)propane,
4,4'-cyanate phenyl oxide,
4,4'-cyanate diphenyl oxide,
4,4'-cyanate diphenylsulfone,
bis(4-cyanate phenyl)phosphine oxide,
bis(4-cyanate phenyl)phenyl phosphine oxide,
bis(4-cyanate phenyl)methylamine,
1,5-cyanate naphthalene,
m-xylene cyanate,
1,1-bis(p-cyanate phenyl)furan,
p-xylylene cyanate,
hexamethylene cyanate,
6,6'-cyanate-2,2-dipyridyl,
4,4-cyanate benzophenone,
4,4'-cyanate azobenzene,
bis(4-cyanate phenyl)phenylmethane,
1,1-bis(4-cyanate phenyl)cyclohexane,
1,1-bis(4-cyanate methylphenyl)-1,3,4-oxadiazole,
4,4'-cyanate diphenyl ether,
4,4-bis(p-cyanate phenyl)-2,2-dithiazole,
m-bis(4-p-cyanate phenyl-2-thiazole)benzene,
4,4-cyanate benzanilide,
4,4'-cyanate phenyl benzoate,
2,2'-bis[4-(4-cyanate phenoxy)phenyl]propane,
2,2'-bis[3-methyl-4-(4-cyanate phenoxy)phenyl]propane,
2,2'-bis[3-ethyl-4-(4-cyanate phenoxy)phenyl]propane,
2,2'-bis[3-propyl-4-(4-cyanate phenoxy)phenyl]propane,
bis[4-(4-cyanate phenoxy)phenyl]methane-1,1,1,3,3,3-hexafluoropropane,
1,1,1,3,3,3-hexachloro-2,2-bis[4-(4-cyanate phenoxy)phenyl]propane,
3,3-bis[4-(4-cyanate phenyl]pentane,
1,1-bis[4-(4-cyanate phenoxy)phenyl]propane,
1,1,1,3,3,3-hexafluoro-2,2-bis[3,5-dimethyl-(4-cyanate phenoxy)phenyl]propane,
1,1,1,3,3,3-hexafluoro-2,2-bis[3,5-dibromo-(4-cyanate phenoxy)phenyl]propane,
1,1,1,3,3,3-hexafluoro-2,2-bis[3,5-dimethyl-(4-cyanate)phenyl]propane, etc.

The cyanate compound can preferably be used in an amount of 40% or less based on the total weight of the cyanate compound and the ether imide compound of the formula (I) in order to obtain a cured product satisfying the objects of the present invention such as excellent heat resistance.

By using the above-mentioned compounds together with the ether imide compound of the formula (I), there can be obtained cured products excellent in flexibility, mechanical properties, fire retardant properties, curing properties, etc.

According to the present invention, a multi-layer wiring substrate for directly mounting chips or chip carriers, as defined in claim 1, can be produced by
(a) placing an ether imide compound of the formula (I) or a composition containing the ether imide compound of the formula (I) on at least one roughened surface of an electrolytic copper foil, followed by heating at 250°C or lower under pressure to form a copper-clad laminate,
(b) forming a circuit pattern on the copper-clad laminate by etching,
(c) piling a plurality of circuit pattern formed copper-clad laminates via adhesive layers containing an ether imide compound of the formula (I) alternately, and
(d) molding at 250°C or lower under pressure.

In the above-mentioned process, the multi-layer copper-clad laminate obtained in the step (c) can be piled on a ceramic wiring substrate via an adhesive layer obtained from the ether imide compound of the formula (I), followed by molding at 250°C or lower under pressure, e.g. 0.5 to 10 kg/cm².

The ether imide compound of the formula (I) can be used in the form of a powder, but the use of it in the form of a solution dissolved in an organic solvent is by far preferable due to improvement in productivity, improvement of high temperature fluidity of the resin in the insulating layer and the adhesive layer containing the compound of the formula (I).

More concretely, a copper-clad laminate can be formed by sandwiching the ether imide compound of the formula (I) alone or together with one or more compounds mentioned above by a pair of electrolytic copper foils and heating for curing. In this case, in order to obtain the uniform thickness, it is preferable to form a spacer around the sample and to form a laminate with heating under pressure.

When the compound of the formula (I) is used as a powder, it can be melted by heating at 100° to 150°C for 5 to 60 minutes, followed by heating at 180° to 250°C for 60 to 240 minutes for curing.

When the compound of the formula (I) is used as a solution, said compound dissolved in an organic solvent such as those mentioned above used for the production of the desired compounds, is uniformly coated on roughened surfaces of the electrolytic copper foil and heated at 80° to 150°C for 10 to 180 minutes to form a prepolymer, which is further heated in a constant temperature bath to remove the solvent. Then, another roughened surface of electrolytic copper foil is piled thereon, followed by curing with heating at 180° to 250°C under pressure of 5 to 40 kg/cm². As the organic solvent, those mentioned above can also be used.

The use of the solution of the compound of the formula (I) is by for better than the use of the powder, considering the productivity, prevention of voids among patterns of the multi-layer wiring substrate, etc.

In order to accelerate the curing reaction, it is possible to add a polymerization initiator to the compound of the formula (I). As the polymerization initiator, there can be used organic peroxides such as benzoyl peroxide, p-chlorobenzoyl peroxide, 2,5-dimethyl-2,5-di(t-butyl peroxy)hexine-3, 2,4-dichlorobenzoyl peroxide, caprylyl peroxide, lauroyl peroxide, acetyl peroxide, methyl ethyl ketone peroxide, cyclohexanone peroxide, bis(1-hydroxycyclohexyl peroxide), hydroxybutyl peroxide, t-butyl hydroperoxide, p-menthane hydroperoxide, t-butyl perbenzoate, t-butyl peracetate, t-butyl peroctoate, t-butyl peroxybutylate, t-butyl diperphthalate, etc. These organic peroxides can be used alone or as a mixture thereof.

The resulting copper-clad laminate is drilled to form holes, followed by electroless plating to form an electroconductive layer on the inner wall of each hole. As a result, a wiring substrate is obtained.

When a plurality of copper-clad laminates are piled via adhesive layers obtained from the ether imide compound of the formula (I) alternately, followed by heating at 170° to 270°C, preferably 200° to 250°C, under a pressure of 5 to 40 kg/cm², for curing a multi-layer substrate.

The resulting multi-layer substrate in a desired number of laminated form thereof is piled on a ceramic wiring board, adhesive layers containing the ether imide compound of the formula (I) being placed between individual multi-layer substrates and between the lowest multi-layer substrate and the ceramic wiring board, followed by heating at 250°C or lower under pressure for curing to finally obtain the multi-layer wiring substrate.

The resulting multi-layer wiring substrate has advantages in that since the ether imide compound of the formula (I) melts at the time of heating for curing, adhesiveness to the conductor is excellent, and since the cured product does not decompose at 350°C or less, connection to chips or chip carriers using solder becomes possible. Further, since the relative dielectric constant is as low as 3.5 or less, and no misregistration of individual substrates takes place, the multi-layer wiring substrate of the present invention is particularly useful for directly mounting chips or chip carriers thereon.

As mentioned above, the multi-layer wiring substrate for directly mounting chips and chip carriers of the present invention is excellent in adhesiveness to the copper conductors as well as adhesiveness between substrates, while showing excellent high temperature fluidity so as to fill spaces of 20 to 50 µm between patterns without forming very fine voids.

The present invention is illustrated by way of the following Examples, in which all parts and percents are by weight unless otherwise specified.

### Example 1

In a 500-ml flask, 100 parts of 2,2-bis[4-(4-maleimidophenoxy)phenyl]propane and 100 parts of methyl ethyl ketone were placed and stirred at room temperature for 30 minutes to give a transparent solution. Then, 0.5 parts of 2,5-dimethyl-2,5-di(t-butyl-oxine)hexine-3, an organic peroxide, so as to accelerate the reaction, were added to the solution and subjected to stirring for further 30 minutes. After removing the organic solvent by an evaporator, the residue was dried in a vacuum drier at 30° to 50°C for 5 hours to give an organic powder. Then, the resulting powder was sandwiched by a pair of electrolytic copper foils of 9 µm thick and attaching aluminum (so as to contact roughened surfaces of copper foils with the organic powder), and heated at 170°C for 30 minutes and 250°C for 120 minutes, under a pressure of 5 kg/cm² using a spacer with the predetermined thickness so as to obtain a uniform film thickness. As a result, a copper-clad laminate was produced.

### Example 2

The same starting materials as used in Example 1 were stirred in a 500-ml flask equipped with a reflux condenser at 100° to 130°C for 120 minutes to give a transparent solution.

The resulting solution was coated on a roughened surface of an electrolytic copper foil of 9 µm and attaching aluminum, and dried at 110°C for 20 minutes in a drier. Then, a roughened surface of another electrolytic copper foil was piled on the solution-coated surface and heated under pressure in the same manner as described in Example 1 to give a copper-clad laminate.

### Example 3

In a 500-ml flask equipped with a reflux condenser, 100 parts of 2,2-bis[3-ethyl-4-(4-maleimidophenoxy)phenyl]propane and 100 parts of methyl Cellosolve were placed and heated at 90° to 110°C for 3 hours to give a transparent solution. Then, 0.5 parts of 2,5-dimethyl-2,5-di(t-butyl-oxine)hexine-3 were added to the solution and stirred for 30 minutes with a glass stirrer to give a transparent solution. The resulting solution was coated on a roughened surface of an electrolytic copper foil of 5 µm thick and attaching aluminum, and dried at 140°C for 20 minutes. Then, a roughened surface of another electrolytic copper foil was piled on the solution coated surface and heated under pressure in the same manner as described in Example 1 to give a copper-clad laminate.

### Example 4

In a 500-ml flask equipped with a reflux condenser, 100 parts of bis[4-(4-maleimidophenoxy)phenyl]methane and 100 parts of methyl Cellosolve were placed and heated at 90° to 110°C for 3 hours to give a transparent solution. Then, 0.5 parts of benzoyl peroxide were added to the solution and subjected to stirring using a glass stirrer for 30 minutes to give a transparent solution. The resulting solution was coated on a roughened surface of an electrolytic copper foil of 9 µm thick and attaching aluminum, and dried at 140°C for 20 minutes. Then, another electrolytic copper foil of 9 µm thick and attaching aluminum was piled on the solution coated surface and heated under pressure in the same manner as described in Example 1 to give a copper-clad laminate.

### Comparative Example 1

In a four-necked flask equipped with a thermometer, a stirrer, a reflux condenser, and a nitrogen introducing pipe, 89.25 parts of 4,4'-diaminodiphenyl ether and 850 parts of N-methyl-2-pyrrolidone were placed. Then, 89.3 parts of 3,3',4,4'-tetracarboxybiphenyl dianhydride were added to the flask, which was immersed in a water bath of 0° to 50°C to control exothermic heat. After dissolution, the water bath was taken off and the reaction was carried out at a temperature near room temperature for about 5 hours to give a varnish of poly(amic acid).

Then, the resulting varnish was coated on a glass plate uniformly using an applicator, dried at 80° to 100°C for 30 to 60 minutes to form a film. The film was peeled off from the glass plate and fixed to an iron frame and maintained at 200°C, 300°C and 400°C for each 1 hour, to form a polyimide film of 20 to 30 µm thick. The resulting film was coated with a catalyst for electroless copper plating and subjected to electroless copper plating to give a copper-clad laminate having the copper film of 10 µm thick.

### Comparative Example 2

In a four-necked flask equipped with a thermometer, a stirrer, a reflux condenser and a nitrogen introducing pipe, 18.09 parts of p-phenylenediamine and 33.49 parts of 4,4'-diamino diphenyl ether were placed. Then, 98.4 parts of 3,3',4,4'-tetracarboxybiphenyl dianhydride were added to the flask, which was immersed in a water bath of 0° to 50°C to control exothermic heat. After dissolution, the water bath was taken off and the reaction was carried out at a temperature near room temperature for about 5 hours to give a varnish of poly(amic acid).

Then, the resulting varnish was coated on a glass plate uniformly using an applicator and dried at 80° to 100°C for 30 to 60 minutes to form a film. The film was peeled off from the glass plate and fixed to an iron frame and heated at 200°C, 300°C and 400°C for each 1 hour to form a polyimide film of 20 to 30 µm thick.

A copper-clad laminate having a copper film of 10 µm thereon by electroless copper plating was prepared in the same manner as described in Comparative Example 1.

Using the samples obtained in Examples 1 to 4 and Comparative Examples 1 and 2, adhesiveness between the copper film and the resin layer, and solder heat resistance at 260°C and 350°C were measured as follows. Further, relative dielectric constants of the (insulating) resin layers were also measured as follows.

### [Adhesive strength]

A test piece of 25 mm width and 100 mm length was cut from a sample so as to retain a copper film at the central portion of 10 mm among the size of 25 mm. The copper film was peeled off vertically at a rate of 50 mm/min to evaluate the adhesive strength.

### [Solder heat resistance]

A test piece of 5 mm length and 5 mm width were cut and floated on a molten solder bath heated at 260°C or 350°C and a time required for producing blisters in the copper film was measured.

### [Relative dielectric constant]

A resin layer of 50 mm length and 50 mm width was cut from a sample and subjected to attachment of electrodes of 40 mm in diameter on both sides thereof to measure electrostatic capacity according to JIS C-6481. Then, the relative dielectric constant was calculated.

The results are shown in Table 1.

**Table 1**

| Example No. | Adhesive strength (for Cu) (kg/cm) | Solder heat resistance (min) | | Relative dielectric constant |
|---|---|---|---|---|
| | | 260°C | 350°C | |
| Example 1 | 0.70 | >10 | >10 | 3.31 |
| Example 2 | 0.83 | >10 | >10 | 3.28 |
| Example 3 | 0.91 | >10 | >10 | 3.23 |
| Example 4 | 0.98 | >10 | >10 | 3.19 |
| Comparative Example 1 | 0.25 | >10 | <1 | 3.50 |
| Comparative Example 2 | 0.39 | >10 | <1 | 3.53 |

(average value of 5 test pieces)

As is clear from Table 1, the copper-clad laminates according to the present invention are excellent in the adhesive strength, and the solder heat resistance (particularly at 350°C). Further, since the relative dielectric constants are small, the signal transfer rate is also excellent.

### Example 5

In a 500-ml flask equipped with a reflux condenser, 80 parts of 2,2'-bis[4-(4-maleimidophenoxy)phenyl]propane, 20 parts of 2,2'-bis[4-(4-cyanamidophenoxy)phenyl]propane, and 100 parts of methyl Cellosolve were placed and stirred at 90° to 120°C for 40 minutes to give a transparent solution.

The resulting solution was coated on a roughened surface of an electrolytic copper foil of 9 µm thick and attaching alumina and dried at 140°C for 20 minutes in a constant temperature bath. Then, another electrolytic copper foil of 9 µm thick and attaching alumina was piled on the solution coated surface and heated under pressure in the same manner as described in Example 1 to give a copper-clad laminate.

Further, the above-mentioned solution was coated on a glass plate of 100 mm length, 100 mm width and 2 mm thickness uniformly and heated at 140°C for 20 minutes, 170°C for 60 minutes and 250°C for 120 minutes in a constant temperature bath to give a film.

### Example 6

In a 500-ml flask equipped with a reflux condenser, 80 parts of 2,2'-bis[4-(4-maleimidophenoxy)phenyl]propane, 20 parts of 1,1,1,3,3,3-hexafluoro-2,2-bis[3,5-methyl-(4-cyanamidophenoxy)phenyl]propane, and 100 parts of methyl Cellosolve were placed, and stirred at 90° to 120°C for 40 minutes to give a transparent solution.

The resulting solution was coated on a roughened surface of an aluminum attached electrolytic copper foil of 9 µm thickness and dried at 140°C for 20 minutes in a constant temperature bath. Then, another aluminum-attached electrolytic copper foil of 9 µm thickness was piled on the solution coated surface and heated under pressure in the same manner as described in Example 1 to give a copper-clad laminate.

Further, the above-mentioned solution was coated on a glass plate of 100 mm length, 100 mm width and 2 mm thickness uniformly and heated at 140°C for 20 minutes, 170°C for 60 minutes and 250°C for 120 minutes in a constant temperature bath to give a film.

### Example 7

In a 500-ml flask equipped with a reflux condenser, 70 parts of 2,2'-bis[4-(4-maleimidophenoxy)phenyl]propane, 30 parts of 4,4'-cyanate diphenylmethane, and 100 parts of methyl Cellosolve were placed and stirred at 110°C for 60 minutes to give a transparent solution.

The resulting solution was coated on a roughened surface of an aluminum-attached electrolytic copper foil of 9 µm thick and dried at 140°C for 20 minutes in a constant temperature bath. Then, another aluminum-attached electrolytic copper foil of 9 µm thickness was piled on the solution coated surface and heated under pressure in the same manner as described in Example 1 to give a copper-clad laminate.

Further, the above-mentioned solution was coated on a glass plate of 100 mm length, 100 mm width, and 2 mm thickness uniformly and heated at 140°C for 20 minutes, 170°C for 60 minutes and 250°C for 120 minutes in a constant temperature bath to give a film.

### Comparative Example 3

In a 500-ml flask equipped with a reflux condenser, 80 parts of 4,4'-dicyanamidodiphenylmethane, 20 parts of 4,4'-bismaleimide diphenylmethane, and 100 parts of methyl Cellosolve were placed and stirred at 90°C for 60 minutes to give a transparent solution.

The resulting solution was coated on a roughened surface of an aluminum-attached electrolytic copper foil of 9 µm thick and dried at 140°C for 20 minutes in a constant temperature bath. Then, another aluminum-attached electrolytic copper foil of 9 µm thickness was piled on the solution coated surface and heated under pressure in the same manner as described in Example 1 to give a copper-clad laminate.

Further, the above-mentioned solution was coated on a glass plate of 100 mm length, 100 mm width, and 2 mm thickness uniformly and heated at 140°C for 20 minutes, 170°C for 60 minutes and 250°C for 120 minutes in a constant temperature bath to give a film.

Using individual samples obtained in Examples 5 to 7 and Comparative Example 3, the adhesive strength and the solder heat resistance at 350°C were measured in the same manner as described in Examples 1 to 4. Further, the generation of cracks on the film when peeled off from the glass plate and thermal decomposition temperature of the film were also meansured as mentioned below as to the films obtained in Examples 5 to 7 and Comparative Example 3.

### [Cracks on film]

The films were taken off from the glass plate using a single-edge knife and generation of cracks on the films was observed by the naked eye.

### [Thermal decomposition temperature]

Weight change of the films was measured using a high speed differential thermal balance (TGD-7000RH type, mfd. by Shinku Riko K.K.) wherein 10 mg of a sample was heated at a temperature rise rate of 5°C/min under an air flow rate of 100 cm²/min. The temperature showing 5% weight loss was defined as the thermal decomposition temperature.

The results are shown in Table 2.

**Table 2**

| Example No. | Adhesive strength (for Cu) (kg/cm) | Solder heat resistance at 350°C (min) | Cracks on film | Thermal decomposition temperature (°C) |
|---|---|---|---|---|
| Example 5 | 1.02 | >10 | None | 405 |
| Example 6 | 0.99 | >10 | None | 418 |
| Example 7 | 1.30 | >10 | None | 390 |
| Comparative Example 3 | 1.35 | <5 | Yes | 370 |

(average value of 5 test pieces)

As is clear from Table 2, the copper-clad laminates according to the present invention are excellent in the adhesive strength (for copper) and the solder heat resistance (at 350°C). Further, the films of the present invention handly generate cracks and are excellent in flexibility. In addition, the films of the present invention are high in the thermal decomposition temperature and thus stable in properties.

### Example 8

The copper surfaces of the copper-clad laminate obtained in Example 1 were roughened in an aqueous solution of ferric chloride in a concentration of 200 ml/ℓ (liquid temperature 45°C) for 15 seconds, followed by dipping in an aqueous solution (72°C) of NaOH (15 g/ℓ), NaPO₄·12H₂O (30 g/ℓ) and NaClO₂ (90 g/ℓ) for 120 seconds to form organic oxidized films on the surfaces.

Five sheets of the thus treated were piled while inserting the organic powder obtained in Example 1 among individual layers and heated under pressure at 170°C for 30 minutes and 250°C for 120 minutes, each at 5 kg/cm² to give a multi-layer copper-clad laminate.

### Example 9

The copper-clad laminate obtained in Example 2 was treated in the same manner as described in Example 8 to form organic oxidized films.

Then, the varnish obtained in Example 2 was uniformly coated on one surface of the thus obtained films, followed by drying at 110°C for 20 minutes in a drier.

Five sheets of thus coated copper-clad laminates were piled and heated under pressure in the same manner as described in Example 5 to give a multi-layer copper clad laminate.

### Example 10

The copper-clad laminate obtained in Example 3 was treated in the same manner as described in Example 8 to form organic oxidized films on the copper surfaces.

Then, the varnish obtained in Example 3 was uniformly coated on one surface of the thus obtained films, followed by drying at 140°C for 20 minutes in a drier.

Five sheets of thus coated copper-clad laminates were piled and heated under pressure in the same manner as described in Example 5 to give a multi-layer copper-clad laminate.

### Example 11

The copper-clad laminate obtained in Example 4 was treated in the same manner as described in Example 8 to form organic oxidized films.

Then, the varnish obtained in Example 4 was uniformly coated on one surface of the thus obtained films, followed by drying at 140°C for 20 minutes in a drier.

Five sheets of thus coated copper-clad laminates were piled and heated under pressure in the same manner as described in Example 8 to give a multi-layer copper-clad laminate.

### Comparative Example 4

The copper-clad laminate obtained in Example 4 was treated in the same manner as described in Example 8 to form organic oxidized films.

Five sheets of the thus treated copper-clad laminates were piled via poly(methyl methacrylate) films between individual layers and heated at 170°C for 30 minutes under a pressure of 5 kg/cm² to give a multi-layer copper-clad laminate.

### Comparative Example 5

Electroconductive patterns were formed on an alumina plate by electroless plating. Then, the varnish obtained in Comparative Example 1 was coated thereon, dried at 80° to 100°C for 30 to 60 minutes, and heated at 200°C, 300°C and 400°C for each 1 hour to form insulating films. The surfaces were made flat by mechanical processing. This process was repeated 5 times to give a multi-layer laminate by the so-called sequential lamination method.

The thus produced multi-layer copper-clad laminates obtained in Examples 8 to 11 and Comparative Examples 4 and 5 were subjected to a heat cycle test.

### [Heat cycle test]

Ten test pieces (50 mm length and 50 mm width) were subjected to cooling at -50°C for 25 minutes, raising the temperature for 20 minutes, and heating at 120°C for 25 minutes, and repeat of this one cycle 10 or 30 times. The number of test pieces bringing about interlaminar peeling among 10 test pieces was counted.

The results are shown in Table 3.

**Table 3**

| Example No. | Yield of multilayer laminate (%) | Heat cycle test (number of interlaminar peeling) | |
|---|---|---|---|
| | | 10 cycles | 30 cycles |
| Example 8 | 100 | 0 | 0 |
| Example 9 | 100 | 0 | 0 |
| Example 10 | 100 | 0 | 0 |
| Example 11 | 100 | 0 | 0 |
| Comparative Example 4 | 80 | 7 | 10 |
| Comparative Example 5 | 10 | 4 | 7 |

### Example 12

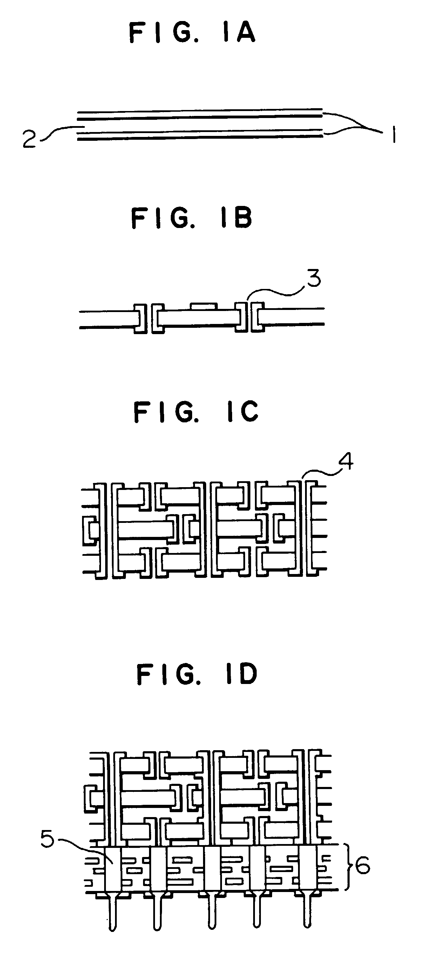

The process for producing the multi-layer wiring substrate of the present invention is explained referring to Figs. 1A to 1D.

In Fig. 1A, a double-sided copper-clad laminate was formed by laminating aluminum-attached copper foil 1 on both sides of an insulating layer 2 of 30 µm thick formed by the same method as described in Example 2.

In Fig. 1B, the aluminum attached to the copper-clad laminate was removed in a solution of NaOH (concentration: 100 g/ℓ). Then, holes 3 having a diameter of 80 µm were formed by excimer laser, followed by formation of a copper film of 20 µm by electroless plating on the inner walls of the holes and the copper foils and etching with cupric chloride to form circuit patterns. The pattern surfaces were roughened with an aqueous solution of ferric chloride (concentration: 200 ml/ℓ) for 15 seconds, followed by dipping in an aqueous solution of NaOH (15 g/ℓ), NaPO·12H₂O (30 g/ℓ) and NaClO₂ (90 g/ℓ) at 72°C for 120 seconds to form organic oxidized films on the surfaces.

In Fig. 1C, the varnish obtained in Example 3 was uniformly coated on one surface of the thus treated copper-clad laminate obtained in Fig. 1B and dried at 140°C for 20 minutes in a drier. Three layers of thus coated laminates were piled and heated at 170°C for 30 minutes and 250°C for 120 minutes, each under a pressure of 5 kg/cm² to form a multi-layer copper-clad laminate. Then, through-holes 4 were formed by a conventional method. In Fig. 1C, the lamination of three layers is exemplified, but it is possible to laminate 40 layers or more.

In Fig. 1D, the varnish obtained in Example 3 was uniformly coated on a ceramic multi-layer substrate 6 having pins 5 for connecting to outer circuits, followed by drying at 140°C for 20 minutes. Then, the multi-layer copper-clad laminate obtained in Fig. 1C was adhered to the varnish-coated surface and heated at 170°C for 30 minutes and 250°C for 120 minutes, each under a pressure of 5 kg/cm² to give a multi-layer wiring substrate.

### Example 13

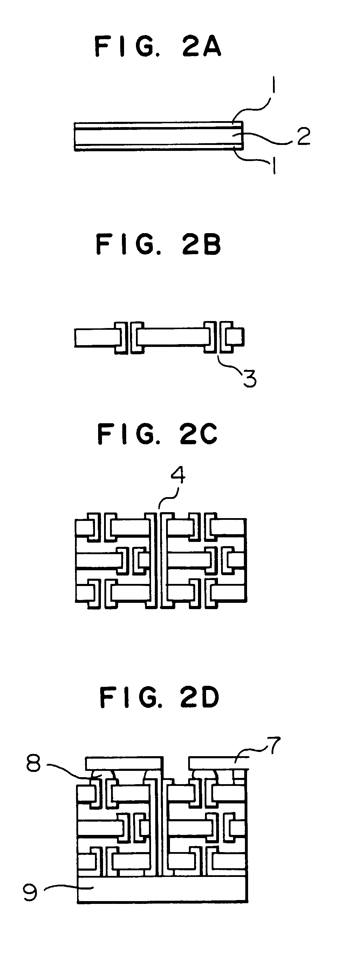

Figs. 2A to 2D illustrate another example of producing the multi-layer wiring substrate of the present invention.

In Fig. 2A, a transparent solution obtained by stirring the same starting material composition as used in Example 1 in a 500-ml flask equipped with a reflux condenser at 100 to 130°C for 120 minutes was coated on a roughened surface of an aluminum-attached electrolytic copper foil 1 of 9 µm thick and dried at 110°C for 20 minutes in a drier to form an insulating layer 2. On the varnish coated surface, the same electrolytic copper foil 1 as mentioned above was piled and heated at 170°C for 30 minutes and 250°C for 120 minutes, each under a pressure of 5 kg/cm² to give a copper-clad laminate having the insulating layer 2 of 20 µm thick.

In Fig. 2B, the aluminum on the copper-clad laminate was removed with an aqueous solution of NaOH (concentration 100 g/ℓ). Then, holes 3 having a diameter of 40 µm were formed by excimer laser, followed by formation of a copper film of 8 µm by electroless plating on the inner walls of the holes and the copper foils and etching with cupric chloride to form circuit patterns. Then, organic oxidized films were formed on the pattern surfaces in the same manner as described in Example 12.

In Fig. 2C, the varnish obtained in Example 3 was uniformly coated on one surface of the thus treated copper-clad laminate obtained in Fig. 2B and dried at 140°C for 20 minutes in a drier. Three layers of thus coated laminates were piled and heated at 170°C for 30 minutes and 250°C for 120 minutes, each under a pressure of 5 kg/cm² to form a multi-layer copper-clad laminate. Then, through-holes 4 were formed by a conventional method. In Fig. 2C, the lamination of three layers is exemplified, but it is possible to laminate 40 layers or more.

In Fig. 2D, the varnish obtained in Example 3 was uniformly coated on a chip carrier 9 of 0.5 mm aqueous and dried at 140°C for 20 minutes in a drier. Then, the multi-layer copper-clad laminate obtained in Fig. 2C was piled on the varnish coated surface and heated at 170°C for 30 minutes and 250°C for 120 minutes, each under a pressure of 0.5 kg/cm² to form a chip carrier type multi-layer copper-clad laminate. Then, LSIs 7 were connected with solder 8 to give a semiconductor module.

As mentioned above, according to the present invention, there is obtained the multi-layer wiring substrate for directly mounting chips or chip carrier excellent in adhesive strength between circuit conductors and insulating layers and between insulating layers.

Further, the process for producing such a multi-layer wiring substrate is simple and lamination of a large number of such wiring substrate becomes possible, with increased yield of the products.

## Claims

1. A multi-layer wiring substrate for directly mounting chips or chip carriers obtained by laminating a plurality of circuit substrates via adhesive layers, each circuit substrate comprising an insulating layer at least one surface of which has a conductor circuit thereon, and at least one of said insulating layer and said adhesive layer being a cured product of an ether imide compound of the formula: 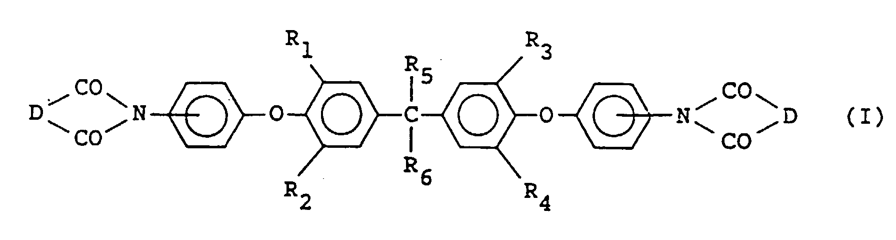 wherein R₁, R₂, R₃ and R₄ are independently a hydrogen atom, an alkyl group having 1 to 6 carbon atoms, an alkoxy group having 1 to 6 carbon atoms, or a halogen atom, R₅ and R₆ are independently a hydrogen atom, a methyl group, an ethyl group, a trifluoromethyl group or a trichloromethyl group, and D is a residue of dicarboxylic acid having one or more ethylenically unsaturated double bonds.

2. The multi-layer wiring substrate according to claim 1, characterized in that it is piled on a ceramic wiring substrate via an adhesive layer formed thereon, which is obtained from the ether imide compound of the formula (I).

3. The multi-layer wiring substrate according to one of claims 1 and 2, characterized in that the cured product further comprises:
- one or several aromatic cyanamide compounds,
- one or several cyanurate compounds, and/or
- one or several cyanate compounds.

4. A process for producing the multi-layer wiring substrate of claim 1 which comprises the following steps:
(a) placing an ether imide compound of the formula (I) or a composition containing the ether imide compound of the formula (I) on at least one roughened surface of an electrolytic copper foil, followed by heating at 250 °C or lower under pressure to form a copper-clad laminate,
(b) forming a circuit pattern on the copper-clad laminate by etching,
(c) piling a plurality of circuit pattern formed copper clad laminates as obtained in steps (a) and (b) via adhesive layers containing the ether imide compound of the formula (I) alternately, and
(d) molding at 250 °C or lower under pressure.

5. The process according to claim 4, characterized in that it further comprises the step of
piling the multi-layer substrate obtained in step (c) on a ceramic wiring substrate via an adhesive layer obtained from the ether imide compound of the formula (I), followed by molding at 250 °C or lower under pressure.

6. The process according to claim 4 or 5, characterized in that the ether imide compound of the formula (I) or the composition containing the ether imide compound of the formula (I) is used in the form of a varnish dissolved in an organic solvent, followed by the removal of the solvent.

## Patentansprüche

1. Mehrlagenverdrahtungssubstrat für die direkte Montage von Chips oder Chipträgern, erhalten durch Laminieren mehrerer Schaltungssubstrate mit Hilfe von Haftschichten zwischen diesen Schaltungssubstraten, wobei jedes Schaltungssubstrat eine Isolierschicht umfaßt, die mindestens eine mit einer Leiterschaltung versehene Oberfläche aufweist, und mindestens eine der Isolierschichten und Haftschichten aus einem gehärteten Produkt einer Etherimidverbindung der folgenden Formel 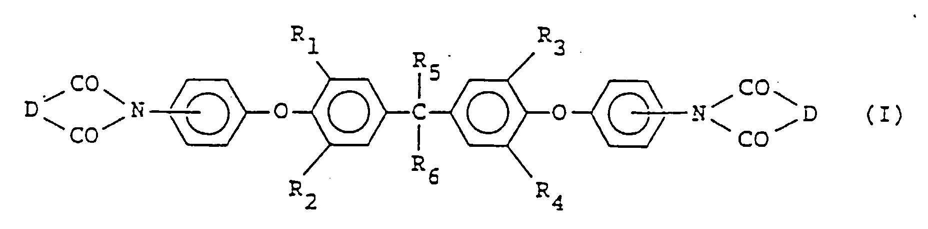 besteht, worin bedeuten:
- R₁, R₂, R₃ und R₄ unabhängig Wasserstoff, C₁₋₆-Alkyl, eine C₁₋₆-Alkoxy oder ein Halogenatom,
- R₅ und R₆ unabhängig Wasserstoff, Methyl, Ethyl, Trifluormethyl oder Trichlormethyl, und
- D einen Dicarbonsäurerest mit einer oder mehreren ethylenisch ungesättigten Doppelbindungen.

2. Mehrschichtenverdrahtungssubstrat nach Anspruch 1,
dadurch gekennzeichnet, daß
es auf einem keramischen Verdrahtungssubstrat mit Hilfe einer darauf erzeugte Haftschicht gestapelt ist, die aus der Etherimidverbindung der Formel (I) hergestellt wurde.

3. Mehrschichtenverdrahtungssubstrat nach einem der Ansprüche 1 und 2,
dadurch gekennzeichnet, daß
das gehärtete Produkt außerdem enthält:
- eine oder mehrere aromatische Cyanamidverbindungen,
- eine oder mehrere Cyanuratverbindungen,
- eine oder mehrere Cyanatverbindungen.

4. Verfahren zur Herstellung des Mehrlagenverdrahtungssubstrats nach Anspruch 1, das folgende Schritte umfaßt:
(a) Aufbringen einer Etherimidverbindung der Formel (I) oder einer Zusammensetzung, die die Etherimidverbindung der Formel (I) enthält, auf mindestens eine aufgerauhte Oberfläche einer elektrolytischen Kupferfolie, worauf Erwärmen auf 250 °C oder darunter unter Druck unter Erzeugung eines kupferbeschichteten Laminats,
(b) Erzeugen eines Schaltungsmusters auf dem kupferbeschichteten Laminat durch Ätzen,
(c) Übereinanderstapeln mehrerer mit Schaltungsmustern versehener kupferbeschichteter Laminate, die nach den Schritten (a) und (b) hergestellt wurden, mit Hilfe von dazwischenliegenden Haftschichten, die die Etherimidverbindung der Formel (I) enthalten und
(d) Formen bei 250 °C oder einer niedrigeren Temperatur unter Druck.

5. Verfahren nach Anspruch 4,
dadurch gekennzeichnet, daß
es ferner den folgenden Schritt umfaßt, bei dem das in Schritt (c) erhaltene Mehrschichtensubstrat mit Hilfe einer dazwischenliegenden Haftschicht, die aus der Etherimidverbindung der Formel (I) erhalten wurde, auf einem keramischen Vedrahtungssubstrat gestapelt wird, worauf das Formen bei 250 °C oder einer niedrigeren Temperatur unter Druck folgt.

6. Verfahren nach Anspruch 4 oder 5,
dadurch gekennzeichnet, daß
die Etherimidverbindung der Formel (I) oder die Zusammensetzung, die die Etherimidverbindung der Formel (I) enthält, in Form eines in einem organischen Lösungsmittel gelösten Lackes verwendet wird, worauf die Entfernung des Lösungsmittels folgt.

## Revendications

1. Substrat à circuits, à couches multiples, pour le montage direct de microplaquettes ou de supports intermédiaires obtenu par formation d'un stratifié de plusieurs substrats à circuits par l'intermédiaire de couches adhésives, chaque substrat à circuits comprenant une couche isolante dont au moins une surface porte un circuit conducteur, et l'une au moins de ladite couche isolante et de ladite couche adhésive étant un produit durci d'un composé de type éther-imide de formule: 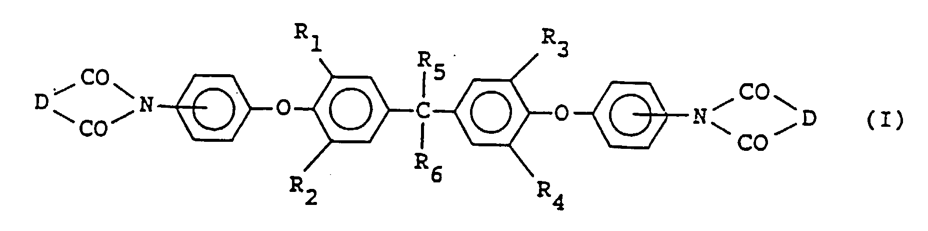 dans laquelle R₁, R₂, R₃ et R₄, représentent indépendamment un atome d'hydrogène, un groupe alkyle ayant 1 à 6 atomes de carbone, un groupe alcoxy ayant 1 à 6 atomes de carbone, ou un atome d'halogène, R₅ et R₆ représentent indépendamment un atome d'hydrogène, un groupe méthyle, un groupe éthyle, un groupe trifluorométhyle ou un groupe trichlorométhyle, et D représente un reste d'un acide dicarboxylique ayant une ou plusieurs doubles liaisons éthyléniquement insaturées.

2. Substrat à circuits, à couches multiples, selon la revendication 1, caractérisé en ce qu'il est empilé sur un substrat à circuits, en céramique, par l'intermédiaire d'une couche adhésive formée sur celui-ci, qui est obtenue à partir du composé de type éther-imide de formule (I).

3. Substrat à circuits, à couches multiples, selon l'une des revendications 1 et 2, caractérisé en ce que le produit durci comprend, en outre :
- un ou plusieurs composés de type cyanamide aromatique,
- un ou plusieurs composés de type cyanurate,
- un ou plusieurs composés de type cyanate.

4. Procédé de production du substrat à circuits, à couches multiples, selon la revendication 1, qui comprend les étapes consistant à :
(a) placer un composé de type éther-imide de formule (I) ou une composition contenant le composé de type éther-imide de formule (I) sur au moins une surface rendue rugueuse d'une feuille de cuivre électrolytique, puis chauffer à 250°C ou moins, sous pression, pour former un stratifié plaqué de cuivre,
(b) former un motif de circuits sur le stratifié plaqué de cuivre par attaque,
(c) empiler plusieurs stratifiés plaqués de cuivre sur lesquels sont formés des motifs de circuits, tels qu'obtenus dans les étapes (a) et (b), en interposant, en alternance, des couches adhésives contenant le composé de type éther-imide de formule (I), et
(d) mouler à 250°C ou moins, sous pression.

5. Procédé selon la revendication 4, caractérisé en ce qu'il comprend, en outre, l'étape consistant à
empiler le substrat à couches multiples obtenu dans l'étape (c) sur un substrat à circuits, en céramique, par l'intermédiaire d'une couche adhésive obtenue à partir du composé de type éther-imide de formule (I), puis mouler à 250°C ou moins, sous pression.

6. Procédé selon la revendication 4 ou 5, caractérisé en ce que l'on utilise le composé de type éther-imide de formule (I) ou la composition contenant le composé de type éther-imide de formule (I) sous la forme d'un vernis dissous dans un solvant organique, puis on élimine le solvant.
